# EUROPEAN PATENT APPLICATION

(11) **EP 2 587 546 A2**
(43) Date of publication of application: **01.05.2013**
(21) Application number: 12181729.0
(22) Date of filing: 24.08.2012
(51) Int. Cl.: H01L 31/0224, H01L 31/048, H01L 31/05

(54) **Solar cell and solar cell module**

(30) Priority: 27.10.2011 TW 100139125
(71) Applicant: Motech Industries Inc., 22204 New Taipei City (TW)
(72) Inventor: Chou, Ming-Tzu, 50441 Sioushuei Township (TW); Chen, Chien-Wen, 93248 Sinyuan Township (TW); Tu, Ching-Hao, 70154 Tainan City (TW); Huang, Chih-Chiang, 71075 Tainan City (TW); Lin, Kang-Cheng, 23447 New Taipei City (TW)
(74) Representative: Regimbeau

(57) **Abstract**

A solar cell module includes multiple solar cells (2) connected in series through wiring units (3). Each solar cell (2) includes a bus bar electrode (23) and multiple finger electrodes (24) disposed on a photoelectric conversion unit (21) converting solar energy into electrical energy. At least one finger electrode (24) has first and second conducting sections (25, 26) connected with each other. The first conducting section (25) is disposed between the bus bar electrode (23) and the second conducting section (26). The second conducting section (26) is thicker than the first conducting section and the bus bar electrode (23).

## Description

The invention relates to a solar cell, and more particularly to a crystalline silicon solar cell and solar cell module.

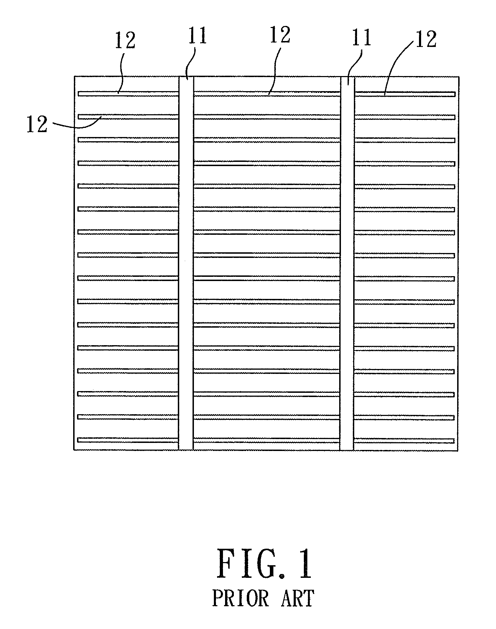

Referring to Figure 1, a conventional silicon crystal solar cell is shown to include two bus bar electrodes 11 extending in a longitudinal direction, and a plurality of finger electrodes 12 extending in a transverse direction. The finger electrodes 12 are formed using a double printing technique such that each finger electrode 12 has a higher aspect ratio to enhance photocurrent collection, thereby obtaining higher conversion efficiency. Since conductive materials for electrode formation by screen printing are expensive, in order to reduce a fabrication cost, the bus bar electrodes 11 are usually not printed twice when practicing the double printing technique.

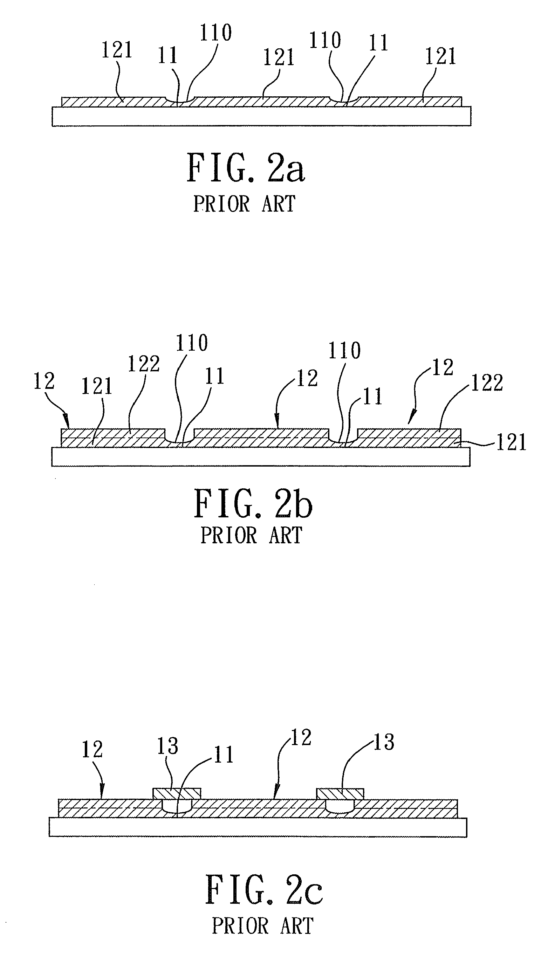

The bus bar electrodes 11 may be formed in a first or second screen printing step of the double printing technique. In the case that the bus bar electrodes 11 are formed in the first screen printing step, the screen pattern for the first screen printing step has portions respectively corresponding to the bus bar electrodes 11 and the finger electrodes 12 so as to form the bus bar electrodes 11 and lower portions 121 of the finger electrodes 12 in the first screen printing step, as shown in Figure 2a. Then, as shown in Figure 2b, upper portions 122 of the finger electrodes 12 disposed respectively on the lower portions 121 are formed in the second screen printing step. As a result, the finger electrodes 12 are thicker than the bus bar electrodes 11. It is noted that, since the screen printing direction (the moving direction of the squeegee) is parallel to the transverse direction (the direction the finger electrodes 12 extends along), bus bar electrodes 11 have a concave top surface 110 . Finally, a plurality of such solar cells and other elements are packaged into a solar cell module, wherein two adjacent solar cells are connected electrically to each other through conductive wires 13, such as ribbons, by soldering (see Figure 2c). The bus bar electrodes 11 are usually designed to have a small width for cost considerations, and the bus bar electrodes 11 may be narrower than the conductive wires 13. Since the finger electrodes 12 are thicker than the bus bar electrodes 11, a conductive wire 13 for being soldered to the corresponding bus bar electrode 12 might be suspended above it, thereby resulting in poor solder connection between the conductive wire 13 and the corresponding bus bar electrode 12. Thus, the conductive wires 13 may peel off from the solar cells in the packaging process.

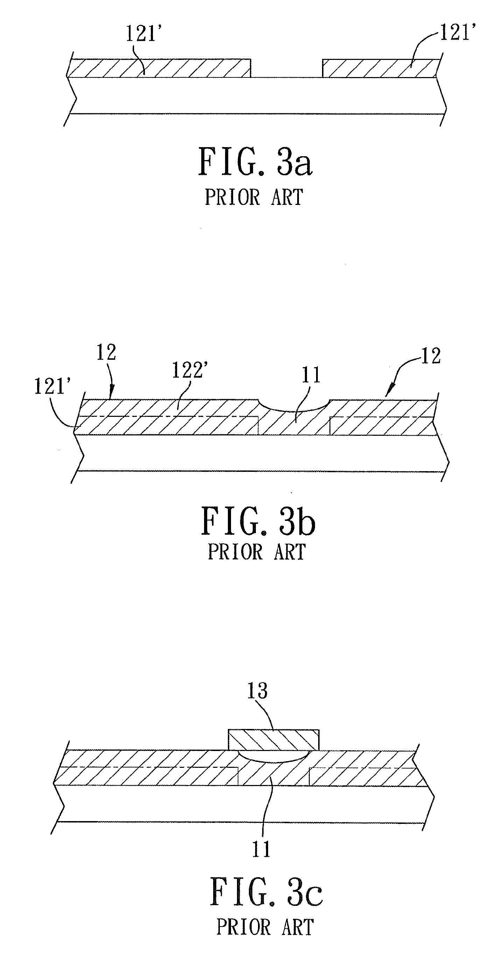

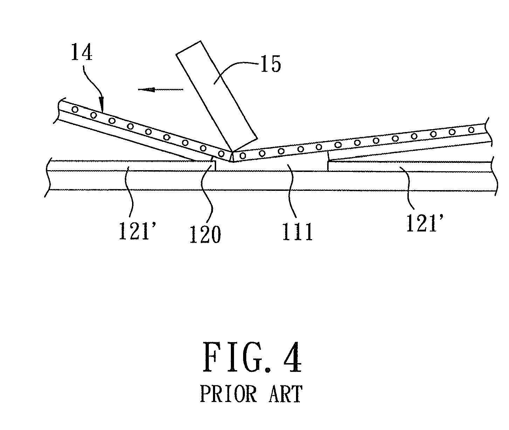

On the other hand, in the case that the bus bar electrodes 11 are formed in the second screen printing step, lower portions 121' of the finger electrodes12 are formed in the first screen printing step, as shown in Figure 3a. Then, as shown in Figure 3b, the bus bar electrodes 11 and upper portions 122' of the finger electrodes 12 disposed respectively on the lower portions 121' are formed in the second screen printing step. As illustrated, poor solder connection between a conductive wire 13 and a corresponding bus bar electrode 11 may occur, as shown in Figure 3c. In addition, referring to Figure 4, for an area 111 on which the bus bar electrode is formed, the end portion 120 of a lower portion 121' may affect the effectiveness of a screen 14 and a squeegee 15 used in the second screen printing step when the squeegee 15 moves in a direction indicated by an arrow in the Figure 4. The conductive material cannot be fully deposited onto the area 111 thereby result in an undesired concave top surface of the bus bar electrode.

Therefore, improvements may be made to the above techniques.

Therefore, an object of the present invention is to provide a solar cell and a solar cell module that can overcome the aforesaid drawbacks of the prior art.

According to one aspect of the present invention, a solar cell comprises a photoelectric conversion unit, a bus bar electrode, and a plurality of finger electrodes. The photoelectric conversion unit converts solar energy into electrical energy. The bus bar electrode is disposed on the photoelectric conversion unit. The finger electrodes are disposed on the photoelectric conversion unit. At least one of the finger electrodes has first and second conducting sections connected with each other. The first conducting section of the at least one of the finger electrodes is disposed between the bus bar electrode and the second conducting section of the at least one of the finger electrodes. The second conducting section of the at least one of the finger electrodes is thicker than the first conducting section of the at least one of the finger electrodes and the bus bar electrode.

According to another aspect of the present invention, a solar cell module comprises a plurality of solar cells, and a plurality of wiring units.

The solar cells are connected in series. Each of the solar cells includes a photoelectric conversion unit, a bus bar electrode, and a plurality of finger electrodes. For each of solar cells, the photoelectric conversion unit converts solar energy into electrical energy. The bus bar electrode is disposed on the photoelectric conversion unit. The finger electrodes are disposed on the photoelectric conversion unit. At least one of the finger electrodes has first and second conducting sections connected with each other. The first conducting section of the at least one of the finger electrodes is disposed between the bus bar electrode and the second conducting section of the at least one of the finger electrodes. The second conducting section of the at least one of the finger electrodes is thicker than the first conducting section of the at least one of the finger electrodes and the bus bar electrode.

The wiring units correspond respectively to the solar cells. Each of the wiring units includes an electrical wire disposed on the bus bar electrode of a corresponding one of the solar cells and is connected electrically to another one of the solar cells adjacent to the corresponding one of the solar cells.

Other features and advantages of the present invention will become apparent in the following detailed description of the preferred embodiments with reference to the accompanying drawings, of which:
Figure 1 is a schematic top view of a conventional solar cell;
Figures 2a, 2b and 2c are schematic sectional views showing a fabrication process of the conventional solar cell;
Figures 3a, 3b and 3c are schematic sectional views showing another fabrication process of the conventional solar cell;
Figure 4 is a schematic side view illustrating how a bus bar electrode is formed in the second screen printing step;
Figure 5 is a schematic top view showing the first preferred embodiment of a solar cell according to the present invention;
Figure 6 is a fragmentary schematic sectional view showing the first preferred embodiment;
Figure 7 is an enlarged view showing an encircled portion of Figure 5;
Figure 8 is a fragmentary schematic top view showing a solar cell module including a plurality of solar cells of the first preferred embodiment without an upper plate body;
Figure 9 is a fragmentary schematic sectional view showing the solar cell module;
Figures 10a and 10b are fragmentary schematic sectional views illustrating how an electrode unit of the first preferred embodiment is formed through a first and a second screen printing steps in order;
Figure 10c is a fragmentary schematic sectional view illustrating how two conductive wires are connected electrically to the first preferred embodiment;
Figure 11 is a schematic view showing a first conductive pattern;
Figure 12 is a schematic view showing a second conductive pattern;
Figure 13a is a fragmentary schematic sectional view showing the second preferred embodiment of a solar cell according to the present invention;
Figure 13b is a schematic view showing an electrode unit of the second preferred embodiment;
Figures 14a and 14b are fragmentary schematic sectional views illustrating how an electrode unit of the second preferred embodiment is formed through first and second screen printing steps in order; and
Figure 14c is a fragmentary schematic sectional view illustrating how two conductive wires are connected electrically to the second preferred embodiment.

Before the present invention is described in greater detail, it should be noted that like elements are denoted by the same reference numerals throughout the disclosure.

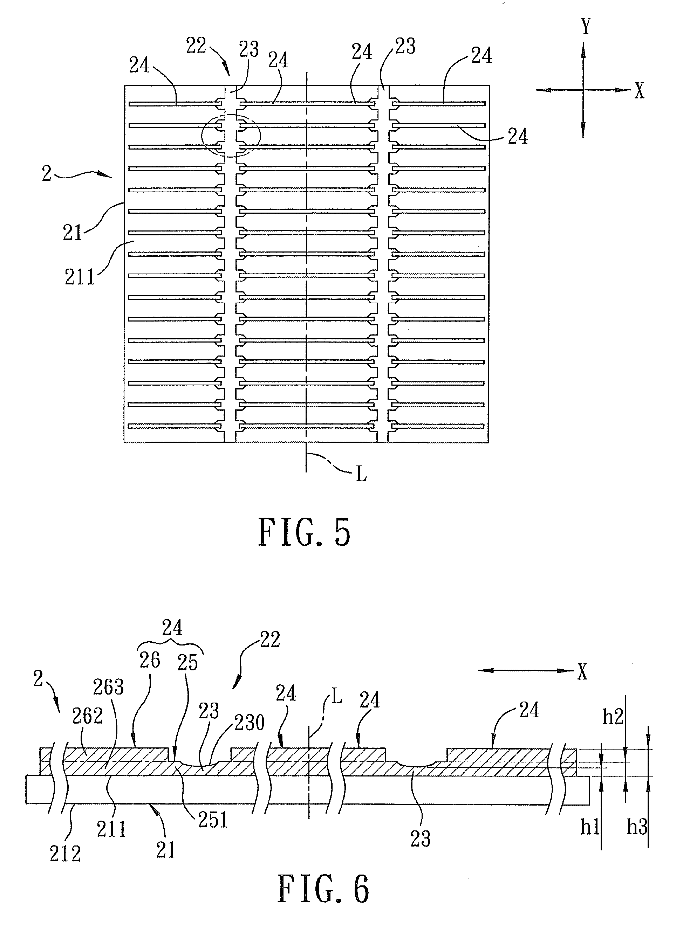

Referring to Figures 5 and 6, the first preferred embodiment of a solar cell 2 according to the present invention is shown to include a photoelectric conversion unit 21, and an electrode unit 22.

The photoelectric conversion unit 21 has a light-receiving surface 211, and a back surface 212 opposite to the light-receiving surface 211. In this embodiment, the photoelectric conversion unit 21 includes a plurality of stacked layer bodies (not shown), for example, a substrate, an emitter layer formed on the substrate, an anti-reflection layer formed on the emitter layer, a passivation layer formed on a back surface of the substrate, and a back surface field (BSF) structure. In the photoelectric conversion unit 21, the emitter layer is made of a semiconductor material generating carriers by irradiation of light. A p-n junction is formed between the substrate and the emitter layer. As a result, when the substrate is a p-type semiconductor layer, the emitter layer is an n-type semiconductor layer. Alternatively, when the substrate is an n-type semiconductor layer, the emitter layer is a p-type semiconductor layer. The anti-reflection layer could be made of silicon nitride (SiNₓ) for reducing reflection of light, enhancing an incident rate of light, and reducing surface recombination velocity (SRV) of carriers. The passivation layer and the BSF structure facilitate enhancement of photoelectric conversion efficiency. Since the feature of this invention does not reside in the configuration of the photoelectric conversion unit 21, which is known to those skilled in the art, details of the same are omitted herein for the sake of brevity.

The electrode unit 22 is disposed on the light-receiving surface 211 of the photoelectric conversion unit 21. In this embodiment, the electrode unit 22 includes two elongate bus bar electrodes 23 extending in a first direction (Y), and a plurality of pairs of elongate finger electrodes 24 extending in a second direction (X) perpendicular to the first direction (Y). In Figure 5, the plurality of pairs of the finger electrodes 24 could be divided into two groups arranged symmetrically relative to an imaginary line (L), although the two groups of finger electrodes are still connected electrically. The finger electrodes 24 of each pair flank a corresponding bus bar electrode 23, and are aligned with each other. In this case, each finger electrode 24 has a first conducting section 25 which is connected to the corresponding bus bar electrode 23 and has a thickness (h2). The finger electrode 24 further has a second conducting section 26 connected to the first conducting section 25 such that the second conducting section 26 is connected electrically to the corresponding bus bar electrode 23 through the first conducting section 25. In addition, the second conducting section 26 extends away from the corresponding bus bar electrode 23 and has a thickness (h3) greater than the thickness (h2) of the first conducting section 25 or the thickness of the corresponding bus bar electrode 23. It is noted that, since screen printing is performed along the second direction (X), the bus bar electrode 23 may have a concave top surface 230. In Figure 6, the thickness of the corresponding bus bar electrode 23 has a minimum value indicated by h1. As such, the non-fixed thickness of the corresponding bus bar electrode 23 is less than or equal to the thickness (h2) of the first conducting sections 25.

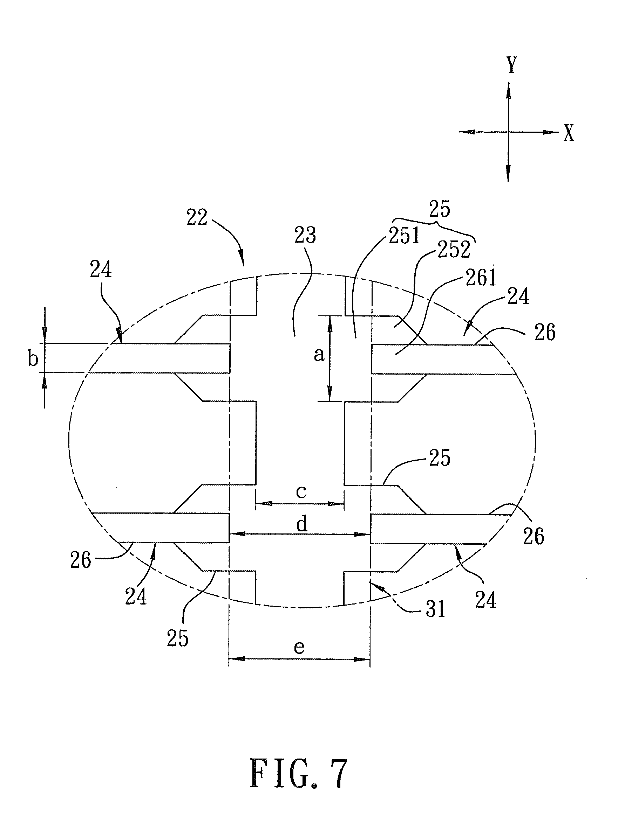

Referring further to Figure 7, the first conducting section 25 has a connecting end portion 252 connected to the second conducting section 26, and a buffer end portion 251 connected between the connecting end portion 252 and the corresponding bus bar electrode 23. In this embodiment, the buffer end portion 251 has a fixed width (a) in the first direction (Y) that serves as a maximum width of the first conducting section 25. The width connecting end portion 252 becomes narrower in the direction leaving the corresponding buffer end portion 251.

The second conducting section 26 has a maximum width (b) in the first direction (Y) which is less than the maximum width (a) of the first conducting section 25, i. e. , a > b. Preferably, a difference between the maximum width (a) and the maximum width (b) is not greater than 0.2mm, i.e., a-b ≦ 0.2mm.

It should be noted that the first conductive section 25 could also be designed to have a maximum width equal to that of the second conductive section 26. In this special case, the first conductive section 25 does not include a connecting end portion 252 but only a buffer end portion 251.

Referring to Figure 6 and Figure 7, the second conducting section 26 further has a lower layer portion 263, and an upper layer portion 262 stacked on the lower layer portion 263. In this embodiment, the connecting end portion 252 and the buffer end portion 251 of the first conducting section 25 surround and are connected electrically to an end part 261 of the second conducting section 26. Furthermore, the corresponding bus bar electrode 23 has a width (c) in the second direction (X) not larger than 3mm, i.e., c ≦ 3mm. Preferably, a difference between a minimum distance (d) between the second conducting sections 26 of a pair of finger electrodes 24 in the second direction (X), and the width (c) of the corresponding bus bar electrode 23 is not less than 0.01mm, i.e., d - c ≧ 0.01mm.

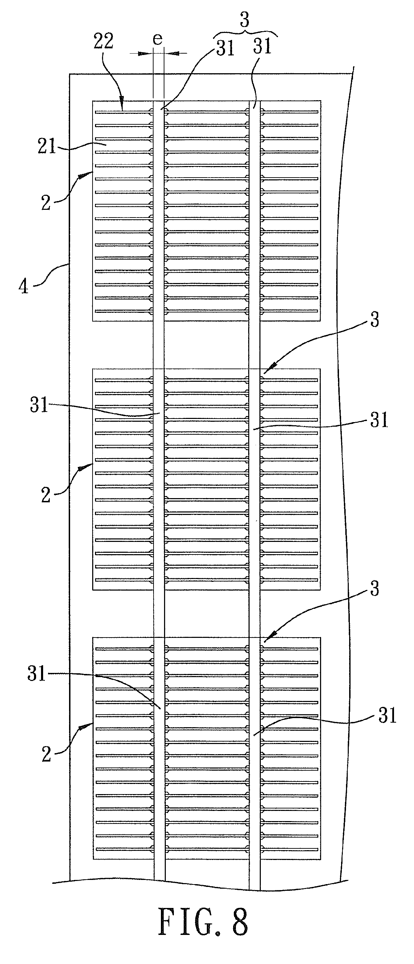

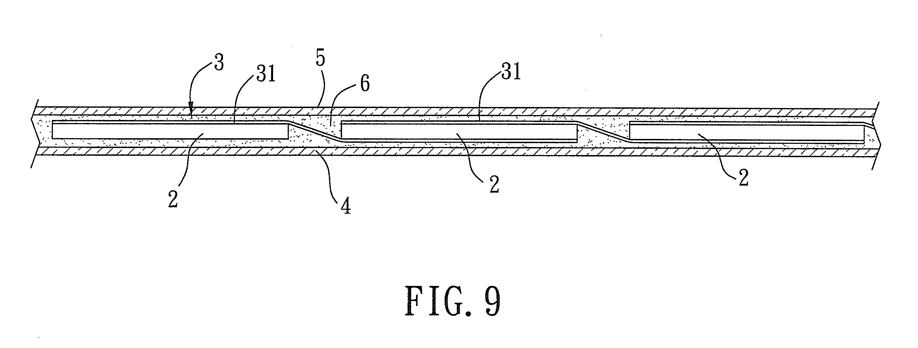

Referring to Figures 8 and 9, a solar cell module is shown to include a lower plate 4, a plurality of the solar cells 2 of the first preferred embodiment, a plurality of wiring units 3, and a transparent upper plate 5. The solar cells 2 are connected in series using the wiring units 3.

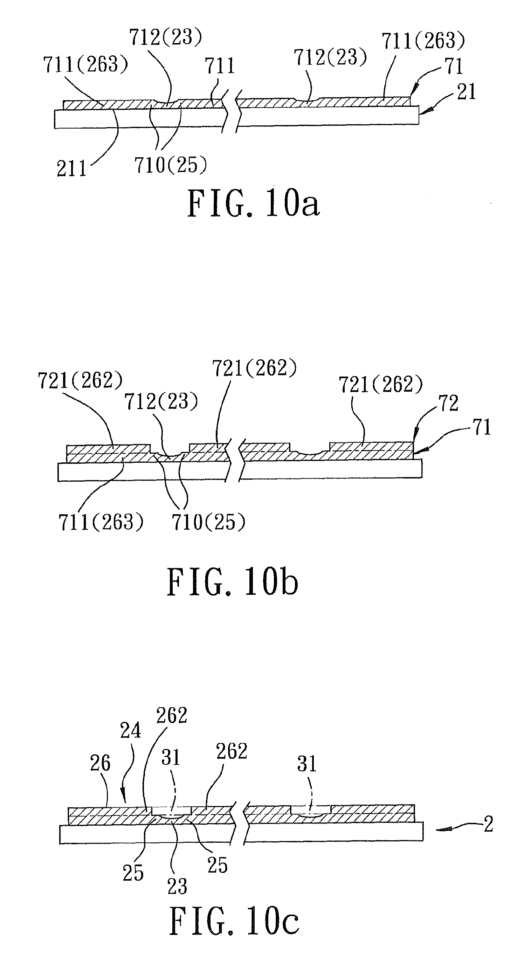

Each wiring unit 3 is connected electrically between corresponding two adjacent solar cells 2. In this embodiment, each wiring unit 3 includes two conductive wires 31 each disposed on a corresponding bus bar electrode 23 of one of the corresponding two adjacent solar cells 2. The two conductive wires 31 are connected directly to the first conducting sections 25 of the finger electrodes 24 of said one of the corresponding two adjacent solar cells 2 (see Figure 10c). Each conductive wire 31 has a width (e) (see Figure 8) not larger than the distance (d), i.e., e ≦ d.

In this embodiment, the width (e) of the conductive wire 31 is equal to the distance (d), that is, e=d. The sidewalls of the conductive wire 31 contact the corresponding upper layer portions 262 of the second conductive sections 26. In other embodiments, the width (e) of an conductive wire 31 could be smaller than the distance (d), and the sidewalls of the conductive wire (31) do not contact the corresponding upper layer portions 262.Therefore, conductive wires 31 of wiring units 3 can be easily and securely soldered to the corresponding electrode unit 22 of said one of the corresponding two adjacent solar cells 2, thereby avoiding poor soldering encountered in the prior art.

In addition, conductive wires 31 are further soldered to back electrodes (not shown) of the other one of the corresponding two adjacent solar cells 2, as shown in Figure 9.

An assembly of the solar cells 2 and the wiring units 3 is disposed between the lower and upper plates 4, 5. A package adhesive 6 is filled between the lower and upper plates 4, 5, thereby anchoring the wiring unit 3 to the solder cells. The package adhesive 6 is formed by melting two adhesive films (not shown) each disposed between a corresponding one of the upper and lower plates 4, 5 and the assembly of the solar cells 2 and the wiring units 3. In this embodiment, the package adhesive 6 is made from ethylene-vinyl acetate (EVA) copolymer.

Figures 10a and 10b are fragmentary schematic sectional view illustrating how the electrode unit 22 is formed through first and second screen printing steps.

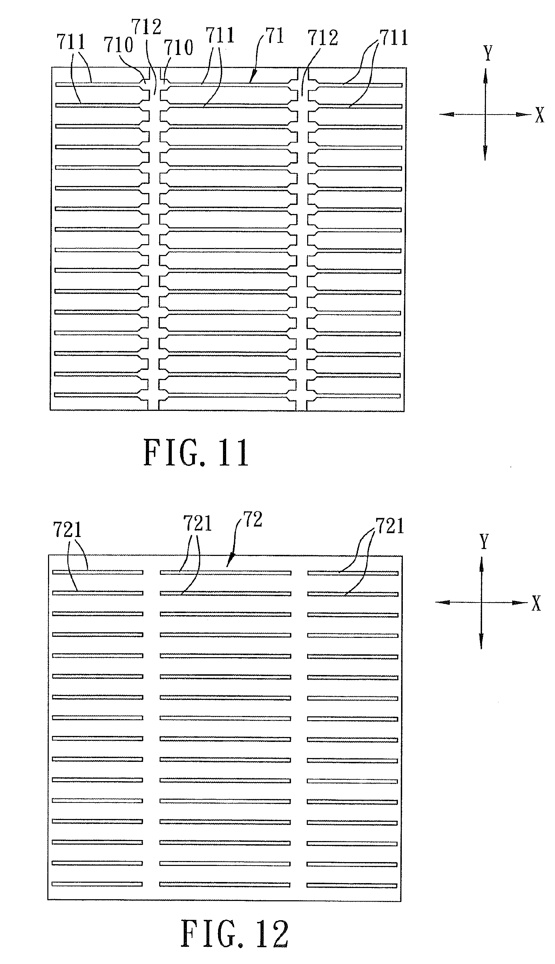

In the first screen printing step, a first conducive pattern 71 shown in Figure 11 is formed on the light-receiving surface 211 of the photoelectric conversion unit 21 (see Figure 10a) using a screen (not shown) having a screen pattern corresponding to the first conductive pattern 71. Then, a process of baking is performed to dry the first conductive pattern 71. The first conductive pattern 71 has two first pattern portions 712 extending in the first direction (Y) and corresponding respectively to the bus bar electrodes 23 of the electrode unit 22, a plurality of second pattern portions 711 extending in the second direction (X) and corresponding to the lower layer portions 263 of the second conducting sections of the finger electrodes, and a plurality of third pattern portions 710 corresponding respectively to the first conducting sections 25 of the finger electrodes, as shown in Figure 10a. Therefore, in this embodiment, conductive pattern portions corresponding to the bus bar electrodes 23, the first conducting sections 25 and the lower layer portions 263 of the second conducting sections of the finger electrodes are formed together in the first screen printing step. It is noted that the third pattern portions 710, which correspond to the future buffer end portions of the first conducting sections 25 of the finger electrodes, are designed to be wider in the first direction (Y), so as to enhance printing saturation for the first conductive patterns 712. That is, printing saturation for the bus bar electrodes 23 can be enhanced (the concave top surface becomes flatter). In addition, there will be larger soldering area for connecting conductive wire 31.

In the second screen printing step, a second conductive pattern 72 shown in Figure 12 is formed on the first conductive pattern 71 using another screen (not shown) having a screen pattern corresponding to the second conductive pattern 72. Then, a process of baking is performed to dry the second conductive pattern 72. The conductive pattern 72 has a plurality of pattern portions 721 extending in the second direction (X), stacked respectively on the second pattern portions 711 of the first conductive pattern 71, and corresponding respectively to the upper layer portions 262 of the finger electrodes. Then, a high-temperature firing process is performed and the combination of the first conductive pattern 71 and second conductive pattern 72 is turned into an electrode unit of the solar cell.

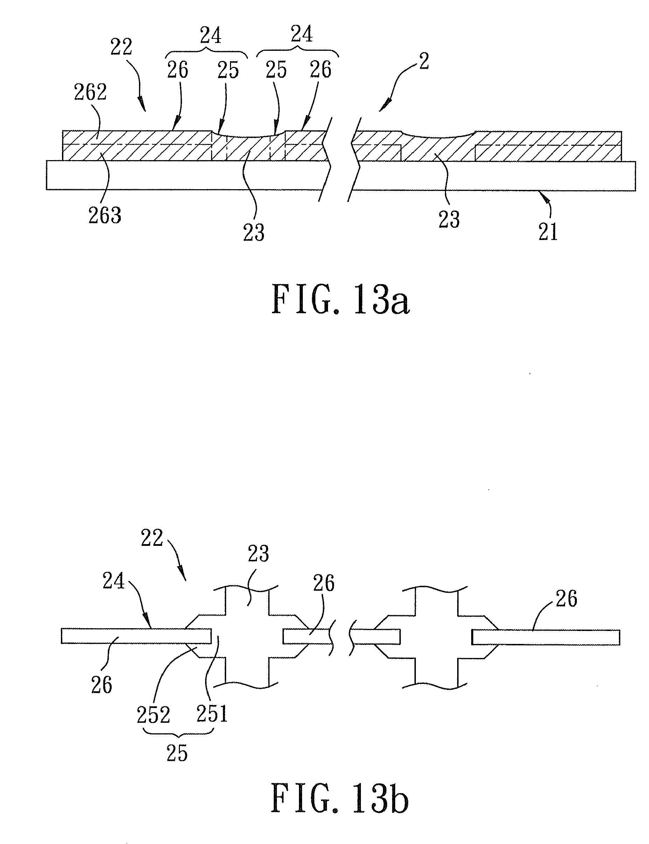

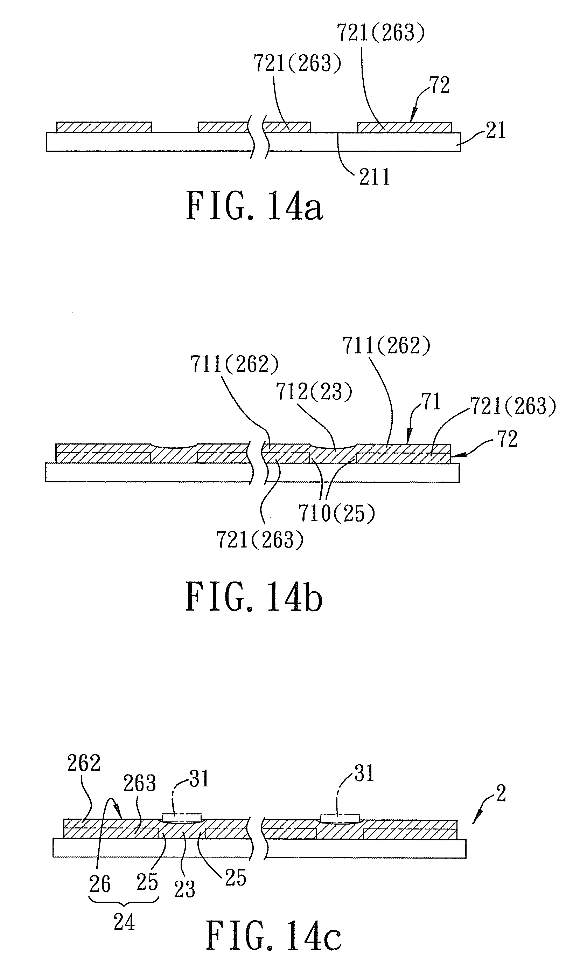

Figure 13a illustrates the second preferred embodiment of a solar cell 2 according to this invention, which is a modification of the first preferred embodiment. In this embodiment, a screen having a screen pattern corresponding to the second conductive pattern 72 shown in Figure 12 is used in the first screen printing step. That is, the second conductive pattern 72 is formed on the light-receiving surface 211 of the photoelectric conversion unit 21. Here, the pattern portions 721 of the second conductive pattern 72 correspond to the lower layer portions 263 of the second conducting sections of the finger electrodes, as shown in Figure 14a. Then, another screen having a screen pattern corresponding to the first conductive pattern 71 shown in Figure 11 is used in a second screen printing step. The first conductive pattern 71 includes pattern portions 712, 711, 710 corresponding respectively to the bus bar electrodes 23, the upper layer portions 262 of the second conducting sections of the finger electrodes, and the first conducting sections 25 of the finger electrodes. The first conducting sections 25 of the finger electrodes 24 have a non-fixed thickness greater than or equal to the thickness of the bus bar electrodes 23. The above-mentioned non-fixed thickness is less than the thickness of the second conducting sections 26 of the finger electrodes 24. Similar to the first preferred embodiment, the combination of the first conductive pattern 71 and the second conductive pattern 72 is turned into the electrode unit of a solar cell after a high-temperature firing process.

It is noted that, although the electrode unit 22 is formed through a fabrication process different from that of the first preferred embodiment, the electrode unit 22 has a similar top-view configuration (see Figure 13b) to that of the first preferred embodiment.

For a solar cell module (not shown) including a plurality of the solar cells 2 of the second preferred embodiment, two adjacent solar cells 2 are connected electrically to each other by two conductive wires 31 each disposed on a corresponding bus bar electrode 23 of one of the corresponding two adjacent solar cells 2, and connected to the first conducting sections 25 of the finger electrodes 24 of said one of the corresponding two adjacent solar cells 2 (see Figure 14c).

Although the figures of this application only show embodiments of which each finger electrode includes a thinner first conductive section and a thicker second conductive section, it is not necessary. An electrode unit could also comprise some finger electrodes like those of the two aforementioned embodiments and the other finger electrodes like those of the conventional solar cell. In this case, the soldering problem could still be improved to some extent. In addition, since the second conductive section 26 is formed by two screen printing steps, the width of the second printed pattern could be larger than that of the first printed pattern to achieve higher aspect ratio.

## Claims

1. A solar cell (2) including a photoelectric conversion unit (21) for converting solar energy into electrical energy, the solar cell (2) being **characterized by**:
a bus bar electrode (23) disposed on the photoelectric conversion unit (21); and
a plurality of finger electrodes (24) disposed on the photoelectric conversion unit (21), at least one of the finger electrodes (24) having first and second conducting sections (25, 26) connected with each other,
wherein the first conducting section (25) of the at least one of the finger electrodes (24) is disposed between the bus bar electrode (23) and the second conducting section (26) of the at least one of the finger electrodes (24), and
wherein the second conducting section (26) of the at least one of the finger electrodes (24) is thicker than the first conducting section (25) of the at least one of the finger electrodes (24) and the bus bar electrode (23).

2. The solar cell (2) as claimed in Claim 1, **characterized in that** the second conducting section (25) of the at least one of the finger electrodes (24) is formed through a first screen printing step and a second screen printing step, the first conducting section (25) of the at least one of the finger electrodes (24) being formed through either the first screen printing step or the second screen printing step.

3. The solar cell (2) as claimed in Claim 2, further **characterized in that** the bus bar electrode (23) and the first conducting section (25) of the at least one of the finger electrodes (24) are formed through the same one of the first and second screen printing steps.

4. The solar cell (2) as claimed in Claim 1, **characterized in that** the base bar electrode (23) and the first conducting section (25) of the at least one of the finger electrodes (24) are formed through the same screen printing step.

5. The solar cell (2) as claimed in Claim 1, **characterized in that** the maximum width of the first conducting section (25) of the at least one of the finger electrodes (24) is a, the maximum width of the second conducting section (26) of the at least one of the finger electrodes (24) is b, and a-b ≦ 0.2mm.

6. The solar cell (2) as claimed in Claim 1, **characterized in that** the second conducting section (26) of the at least one of the finger electrodes (24) has an end part connected to and surrounded by the first conducting section (25) of the at least one of the finger electrodes (24).

7. The solar cell (2) as claimed in Claim 1, **characterized in that**:
two ones of the finger electrodes (24) flank the bus bar electrode (23), each of the two ones of the finger electrodes (24) having the first and second conducting sections (25, 26); and
the width of the bus bar electrode (23) is c, a minimum distance between the second conducting sections (26) of the two ones of the finger electrodes (24) is d, and d-c ≧ 0.01mm.

8. A solar cell module **characterized by**:
a plurality of solar cells (2) connected in series, each of the solar cells (2) including
a photoelectric conversion unit (21) for converting solar energy into electrical energy,
a bus bar electrode (23) disposed on the photoelectric conversion unit (21), and
a plurality of finger electrodes (24) disposed on the photoelectric conversion unit (21), at least one of the finger electrodes (24) having first and second conducting sections (25, 26) connected with each other,
wherein the first conducting section (25) of the at least one of the finger electrodes (24) is disposed between the bus bar electrode (23) and the second conducting section (26) of the at least one of the finger electrodes (24), and
wherein the second conducting section (26) of the at least one of the finger electrodes (24) is thicker than the first conducting section (25) of the at least one of the finger electrodes (24) and the bus bar electrode (23); and
a plurality of wiring units (3) corresponding respectively to the solar cells (2), each of the wiring units (3) including an electrical wire (31) disposed on the bus bar electrode (23) of a corresponding one of the solar cells (2) and connected electrically to another one of the solar cells (2) adjacent to the corresponding one of the solar cells (2).

9. The solar cell module as claimed in Claim 8, **characterized in that**, for each of the wiring units (3), the maximum width of the first conducting section (25) of the at least one of the finger electrodes (24) is a, the maximum width of the second conducting section (26) of the at least one of the finger electrodes (24) is b, and a-b ≦ 0.2mm.

10. The solar cell module as claimed in Claim 8, **characterized in that**, for each of the solar cells (2), the second conducting section (26) of the at least one of the finger electrodes (24) has an end part connected to and surrounded by the first conducting section (25) of the at least one of the finger electrodes (24).

11. The solar cell module as claimed in Claim 8, **characterized in that** the conductive wire (31) of each of the wiring units (3) contacts the first conducting section (25) of the at least one of the finger electrodes (24) of the corresponding one of the solar cells (2).

12. The solar cell module as claimed in Claim 8, **characterized in that** the conductive wire (31) of each of the wiring units (3) is spaced apart from the second conducting section (26) of the at least one of the finger electrodes (24) of the corresponding one of the solar cells (2).

13. The solar cell module as claimed in Claim 8, **characterized in that**, for each of the solar cells (2) :
two ones of the finger electrodes (24) flank the bus bar electrode (23), each of the two ones of the finger electrodes (24) having the first and second conducting sections (25, 26); and
the width of the bus bar electrode (23) is c, a minimum distance between the second conducting sections (26) of the two ones of the finger electrodes (24) is d, and d - c ≧ 0.01mm.

14. The solar cell module as claimed in Claim 13, further **characterized in that** the width of the conductive wire (31) of each of the wiring units (3) is e, and e **≦** d.
